# EUROPÄISCHE PATENTSCHRIFT

(11) **EP 2 476 776 B1**
(45) Veröffentlichungstag und Bekanntmachung des Hinweises auf die Patenterteilung: **12.08.2015**
(21) Anmeldenummer: 11151286.9
(22) Anmeldetag: 18.01.2011
(51) Int. Cl.: C23C 16/04, C23C 10/04, C23C 10/48, F01D 5/18, F01D 5/28

(54) **Verfahren zur Einstellung des Kühlmittelverbrauchs innerhalb aktiv gekühlter Bauteile**
Method for adjusting the coolant consumption within actively cooled components
Procédé de réglage de la consommation en produit de refroidissement dans des composants refroidis activement

(43) Veröffentlichungstag der Anmeldung: 18.07.2012
(73) Patentinhaber: Siemens Aktiengesellschaft, 80333 München (DE)
(72) Erfinder: Ahmad, Fathi, 41564, Kaarst (DE); Halberstadt, Knut, 45481, Mülheim an der Ruhr (DE); Lerner, Christian, 46282, Dorsten (DE)

(56) Entgegenhaltungen:
- EP-A1- 1 672 089
- EP-A2- 1 361 338
- US-A- 5 928 725
- US-A1- 2003 007 870
- US-A1- 2006 263 217

## Beschreibung

Die Erfindung betrifft ein Verfahren zur Einstellung des Kühlmittelverbrauchs innerhalb aktiv gekühlter Bauteile.

Bauteile, die bei hohen Temperaturen eingesetzt werden, wie z.B. Turbinenschaufeln in Gasturbinen, weisen eine aktive Kühlung auf, bei der in das Innere ein Kühlmittel eingeführt wird und durch Kühlmittelkanäle durch die Turbinenschaufel verläuft und ggf. aus Filmkühllöchern austritt.

EP1672089 A1 offenbart ein Verfahren zur Beschichtung von Kühlkanälen.

Dabei ist es wichtig, dass die Turbinenschaufel nicht zu stark gekühlt wird, weil sich dadurch der Kühlmittelverbrauch stark erhöht, was den Wirkungsgrad der Turbine reduzieren würde, weil die Kühlluft meistens dem Kompressor entnommen wird.

Daher ist es wichtig, den Kühlmittelverbrauch durch optimale Einstellung der Durchflussrate einzustellen.

Die Aufgabe wird gelöst durch ein Verfahren gemäß Anspruch 1.

In den Unteransprüchen sind weitere vorteilhafte Maßnahmen aufgelistet, die beliebig miteinander kombiniert werden können, um weitere Vorteile zu erzielen.

Es zeigen
- Figur 1, 2, 3: schematische Darstellungen der Erfindung,
- Figur 4: eine Turbinenschaufel
- Figur 5: eine Gasturbine

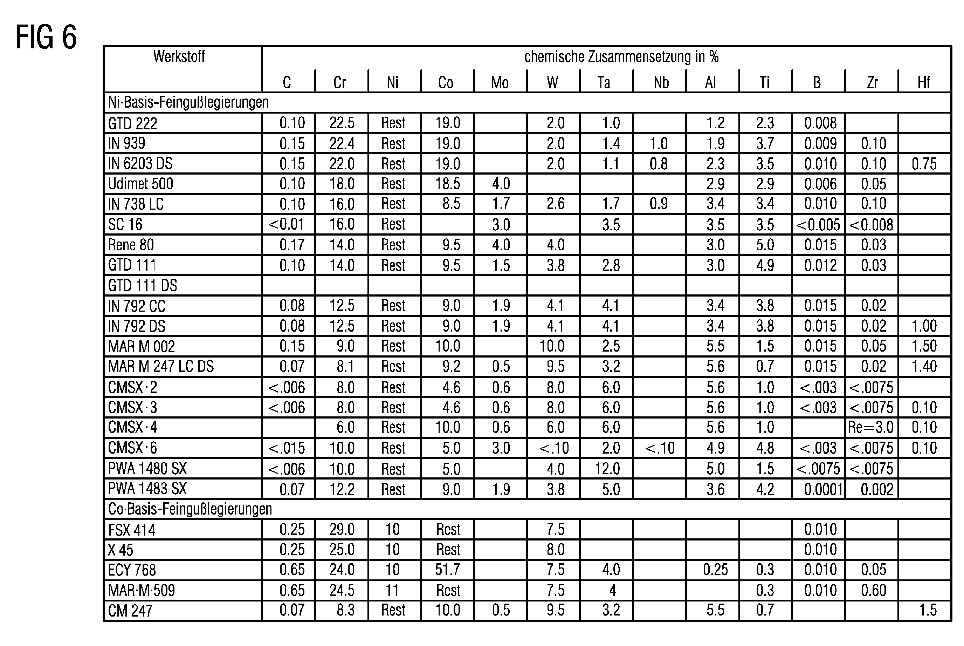

- Figur 6: eine Liste von Superlegierungen.

Die Figuren und die Beschreibung stellen nur Ausführungsbeispiele der Erfindung dar.

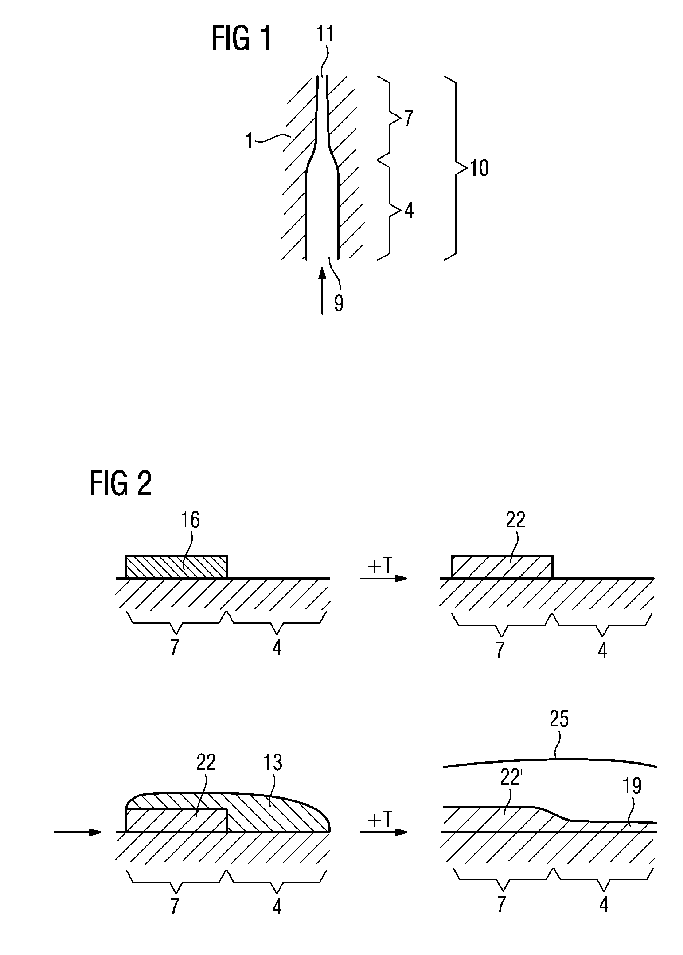

In Figur 1 ist schematisch zumindest ein Teil eines inneren Kanals 10 eines hohlen Bauteils 1 dargestellt.

Der Kanal 10 ist insbesondere ein Kühlkanal 10 und ist in verschiedene Bereiche, hier vorzugsweise in zwei Bereiche 4 und 7 unterteilt, die am Anfang am Eintritt 9 einen größeren Querschnitt aufweisen als am Austritt 11.

Dementsprechend gibt es Bereiche 4, 7 mit unterschiedlichen Strömungsquerschnitten.

Die Bereiche 4, 7 müssen nicht am Eintritt 9 oder am Austritt 11 liegen.

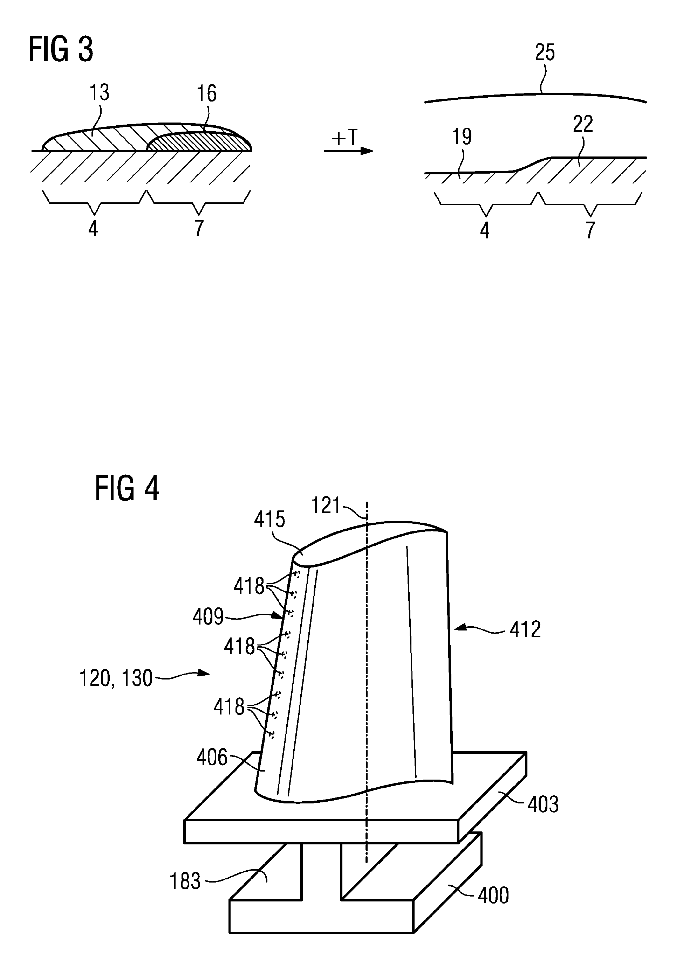

Der Eintritt 9 befindet sich vorzugsweise bei einer Turbinenschaufel im Bereich des Fußes 400 (Fig. 4) und der Austritt 11 vorzugsweise im Bereich der Abströmkante 412 (Fig. 4).

Das Bauteil 1, 120, 130 kann mehrere Kühlkanäle oder mehr als zwei Bereiche aufweisen.

Die Erfindung schlägt vor, die verschiedenen Bereiche 4, 7 mit Diffusionsbeschichtungen zu versehen, die zur Verdickung und damit zu einer Verengung des Durchgangs des Kühlkanals 10 an verschiedenen Bereichen 4, 7 führen.

Ein erstes Verfahren dazu zeigt Figur 2.

Dabei wird durch einen ersten Diffusionsbeschichtungsprozess mittels eines ersten Beschichtungsmaterials 16 nur im ersten Bereich 7 mit dem geringeren Querschnitt eine Diffusionsbeschichtung 22 erzeugt, die zur Wandverdickung führt (+T).

In einem zweiten Schritt wird ein anderes Beschichtungsmaterial 13 in dem ersten 7 und zweiten 4 Bereich aufgebracht, um ebenfalls eine Diffusionsbeschichtung in dem Bereich 4 zu erzeugen, der zu einer zweiten Diffusionsbeschichtung 19 im zweiten Bereich 4 führt. Insbesondere wegen eines anderen Beschichtungsprozesses aufgrund des anderen Beschichtungsmaterials 16 kommt es im Bereich 7 mit dem geringeren Querschnitt zu einer größeren Wandverdickung als im ersten Diffusionsbeschichtungsprozess. Dadurch wird auch der Schichtbereich 22 noch verändert und es entsteht ein dickerer Schichtbereich 22' .

Das Material 16 kann dem Material 13 des zweiten Beschichtungsprozesses entsprechen oder verschieden sein.

Die Diffusionsbeschichtungen 19 und 22' bilden vorzugsweise eine durchgehende Diffusionsbeschichtung 25.

Vorzugsweise ist dies für die Bereiche 4, 7 ein Aluminisierungsprozess, der für den Bereich 4 mit dem größeren Querschnitt vorzugsweise NiAl für den Diffusionsbeschichtungsprozess und/oder für den Bereich 7 mit dem kleineren Querschnitt Ni₂Al₃ zur Diffusionsbeschichtung verwendet wird, wobei die Aktivierungstemperatur für Ni₂Al₃ niedriger ist.

Die beiden Beschichtungsprozesse können auch gleichzeitig angewandt werden, wie es in Figur 3 dargestellt ist.

Das Beschichtungsmaterial 16 ist in dem Bereich 7 mit dem geringeren Querschnitt vorhanden.

Das Beschichtungsmaterial 13 ist in dem Bereich 4 mit dem größeren Querschnitt vorhanden.

Vorzugsweise ist das Material 13 auch über dem Material 16 vorhanden.

Dabei wird vorzugsweise zuerst die Temperatur auf die Temperatur für den ersten Diffusionsbeschichtungsprozess und dann direkt auf die Temperatur des zweiten Diffusionsbeschichtungsprozesses erhöht.

Die Diffusionsbeschichtungen 19 und 22 bilden vorzugsweise eine durchgehende Diffusionsbeschichtung 25.

Vorzugsweise wird der gesamte innere Bereich der Turbinenschaufel 120, 130 beschichtet, insbesondere alitiert.

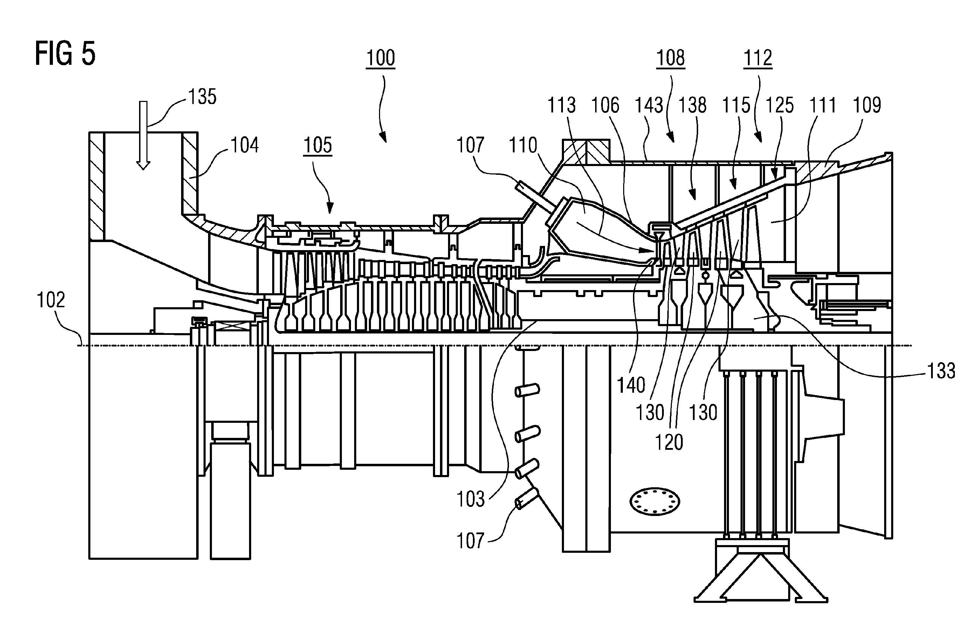

Die Figur 5 zeigt beispielhaft eine Gasturbine 100 in einem Längsteilschnitt.

Die Gasturbine 100 weist im Inneren einen um eine Rotationsachse 102 drehgelagerten Rotor 103 mit einer Welle auf, der auch als Turbinenläufer bezeichnet wird.

Entlang des Rotors 103 folgen aufeinander ein Ansauggehäuse 104, ein Verdichter 105, eine beispielsweise torusartige Brennkammer 110, insbesondere Ringbrennkammer, mit mehreren koaxial angeordneten Brennern 107, eine Turbine 108 und das Abgasgehäuse 109.

Die Ringbrennkammer 110 kommuniziert mit einem beispielsweise ringförmigen Heißgaskanal 111. Dort bilden beispielsweise vier hintereinander geschaltete Turbinenstufen 112 die Turbine 108.

Jede Turbinenstufe 112 ist beispielsweise aus zwei Schaufelringen gebildet. In Strömungsrichtung eines Arbeitsmediums 113 gesehen folgt im Heißgaskanal 111 einer Leitschaufelreihe 115 eine aus Laufschaufeln 120 gebildete Reihe 125.

Die Leitschaufeln 130 sind dabei an einem Innengehäuse 138 eines Stators 143 befestigt, wohingegen die Laufschaufeln 120 einer Reihe 125 beispielsweise mittels einer Turbinenscheibe 133 am Rotor 103 angebracht sind.

An dem Rotor 103 angekoppelt ist ein Generator oder eine Arbeitsmaschine (nicht dargestellt).

Während des Betriebes der Gasturbine 100 wird vom Verdichter 105 durch das Ansauggehäuse 104 Luft 135 angesaugt und verdichtet. Die am turbinenseitigen Ende des Verdichters 105 bereitgestellte verdichtete Luft wird zu den Brennern 107 geführt und dort mit einem Brennmittel vermischt. Das Gemisch wird dann unter Bildung des Arbeitsmediums 113 in der Brennkammer 110 verbrannt. Von dort aus strömt das Arbeitsmedium 113 entlang des Heißgaskanals 111 vorbei an den Leitschaufeln 130 und den Laufschaufeln 120. An den Laufschaufeln 120 entspannt sich das Arbeitsmedium 113 impulsübertragend, so dass die Laufschaufeln 120 den Rotor 103 antreiben und dieser die an ihn angekoppelte Arbeitsmaschine.

Die dem heißen Arbeitsmedium 113 ausgesetzten Bauteile unterliegen während des Betriebes der Gasturbine 100 thermischen Belastungen. Die Leitschaufeln 130 und Laufschaufeln 120 der in Strömungsrichtung des Arbeitsmediums 113 gesehen ersten Turbinenstufe 112 werden neben den die Ringbrennkammer 110 auskleidenden Hitzeschildelementen am meisten thermisch belastet.

Um den dort herrschenden Temperaturen standzuhalten, können diese mittels eines Kühlmittels gekühlt werden.

Ebenso können Substrate der Bauteile eine gerichtete Struktur aufweisen, d.h. sie sind einkristallin (SX-Struktur) oder weisen nur längsgerichtete Körner auf (DS-Struktur).

Als Material für die Bauteile, insbesondere für die Turbinenschaufel 120, 130 und Bauteile der Brennkammer 110 werden beispielsweise eisen-, nickel- oder kobaltbasierte Superlegierungen verwendet.

Solche Superlegierungen sind beispielsweise aus der EP 1 204 776 B1, EP 1 306 454, EP 1 319 729 A1, WO 99/67435 oder WO 00/44949 bekannt.

Die Leitschaufel 130 weist einen dem Innengehäuse 138 der Turbine 108 zugewandten Leitschaufelfuß (hier nicht dargestellt) und einen dem Leitschaufelfuß gegenüberliegenden Leitschaufelkopf auf. Der Leitschaufelkopf ist dem Rotor 103 zugewandt und an einem Befestigungsring 140 des Stators 143 festgelegt.

Die Figur 4 zeigt in perspektivischer Ansicht eine Laufschaufel 120 oder Leitschaufel 130 einer Strömungsmaschine, die sich entlang einer Längsachse 121 erstreckt.

Die Strömungsmaschine kann eine Gasturbine eines Flugzeugs oder eines Kraftwerks zur Elektrizitätserzeugung, eine Dampfturbine oder ein Kompressor sein.

Die Schaufel 120, 130 weist entlang der Längsachse 121 aufeinander folgend einen Befestigungsbereich 400, eine daran angrenzende Schaufelplattform 403 sowie ein Schaufelblatt 406 und eine Schaufelspitze 415 auf.

Als Leitschaufel 130 kann die Schaufel 130 an ihrer Schaufelspitze 415 eine weitere Plattform aufweisen (nicht dargestellt).

Im Befestigungsbereich 400 ist ein Schaufelfuß 183 gebildet, der zur Befestigung der Laufschaufeln 120, 130 an einer Welle oder einer Scheibe dient (nicht dargestellt).

Der Schaufelfuß 183 ist beispielsweise als Hammerkopf ausgestaltet. Andere Ausgestaltungen als Tannenbaum- oder Schwalbenschwanzfuß sind möglich.

Die Schaufel 120, 130 weist für ein Medium, das an dem Schaufelblatt 406 vorbeiströmt, eine Anströmkante 409 und eine Abströmkante 412 auf.

Bei herkömmlichen Schaufeln 120, 130 werden in allen Bereichen 400, 403, 406 der Schaufel 120, 130 beispielsweise massive metallische Werkstoffe, insbesondere Superlegierungen verwendet.

Solche Superlegierungen sind beispielsweise aus der EP 1 204 776 B1, EP 1 306 454, EP 1 319 729 A1, WO 99/67435 oder WO 00/44949 bekannt.

Die Schaufel 120, 130 kann hierbei durch ein Gussverfahren, auch mittels gerichteter Erstarrung, durch ein Schmiedeverfahren, durch ein Fräsverfahren oder Kombinationen daraus gefertigt sein.

Werkstücke mit einkristalliner Struktur oder Strukturen werden als Bauteile für Maschinen eingesetzt, die im Betrieb hohen mechanischen, thermischen und/oder chemischen Belastungen ausgesetzt sind.

Die Fertigung von derartigen einkristallinen Werkstücken erfolgt z.B. durch gerichtetes Erstarren aus der Schmelze. Es handelt sich dabei um Gießverfahren, bei denen die flüssige metallische Legierung zur einkristallinen Struktur, d.h. zum einkristallinen Werkstück, oder gerichtet erstarrt.

Dabei werden dendritische Kristalle entlang dem Wärmefluss ausgerichtet und bilden entweder eine stängelkristalline Kornstruktur (kolumnar, d.h. Körner, die über die ganze Länge des Werkstückes verlaufen und hier, dem allgemeinen Sprachgebrauch nach, als gerichtet erstarrt bezeichnet werden) oder eine einkristalline Struktur, d.h. das ganze Werkstück besteht aus einem einzigen Kristall. In diesen Verfahren muss man den Übergang zur globulitischen (polykristallinen) Erstarrung meiden, da sich durch ungerichtetes Wachstum notwendigerweise transversale und longitudinale Korngrenzen ausbilden, welche die guten Eigenschaften des gerichtet erstarrten oder einkristallinen Bauteiles zunichte machen.

Ist allgemein von gerichtet erstarrten Gefügen die Rede, so sind damit sowohl Einkristalle gemeint, die keine Korngrenzen oder höchstens Kleinwinkelkorngrenzen aufweisen, als auch Stängelkristallstrukturen, die wohl in longitudinaler Richtung verlaufende Korngrenzen, aber keine transversalen Korngrenzen aufweisen. Bei diesen zweitgenannten kristallinen Strukturen spricht man auch von gerichtet erstarrten Gefügen (directionally solidified structures).

Solche Verfahren sind aus der US-PS 6,024,792 und der EP 0 892 090 A1 bekannt.

Ebenso können die Schaufeln 120, 130 Beschichtungen gegen Korrosion oder Oxidation aufweisen, z. B. (MCrAlX; M ist zumindest ein Element der Gruppe Eisen (Fe), Kobalt (Co), Nickel (Ni), X ist ein Aktivelement und steht für Yttrium (Y) und/oder Silizium und/oder zumindest ein Element der Seltenen Erden, bzw. Hafnium (Hf)). Solche Legierungen sind bekannt aus der EP 0 486 489 B1, EP 0 786 017 B1, EP 0 412 397 B1 oder EP 1 306 454 A1.

Die Dichte liegt vorzugsweise bei 95% der theoretischen Dichte.

Auf der MCrAlX-Schicht (als Zwischenschicht oder als äußerste Schicht) bildet sich eine schützende Aluminiumoxidschicht (TGO = thermal grown oxide layer).

Vorzugsweise weist die Schichtzusammensetzung Co-30Ni-28Cr-8Al-0,6Y-0,7Si oder Co-28Ni-24Cr-10Al-0,6Y auf. Neben diesen kobaltbasierten Schutzbeschichtungen werden auch vorzugsweise nickelbasierte Schutzschichten verwendet wie Ni-10Cr-12Al-0,6Y-3Re oder Ni-12Co-21Cr-11Al-0,4Y-2Re oder Ni-25Co-17Cr-10Al-0,4Y-1,5Re.

Auf der MCrAlX kann noch eine Wärmedämmschicht vorhanden sein, die vorzugsweise die äußerste Schicht ist, und besteht beispielsweise aus ZrO₂, Y₂O₃-ZrO₂, d.h. sie ist nicht, teilweise oder vollständig stabilisiert durch Yttriumoxid und/oder Kalziumoxid und/oder Magnesiumoxid.

Die Wärmedämmschicht bedeckt die gesamte MCrAlX-Schicht. Durch geeignete Beschichtungsverfahren wie z.B. Elektronenstrahlverdampfen (EB-PVD) werden stängelförmige Körner in der Wärmedämmschicht erzeugt.

Andere Beschichtungsverfahren sind denkbar, z.B. atmosphärisches Plasmaspritzen (APS), LPPS, VPS oder CVD. Die Wärmedämmschicht kann poröse, mikro- oder makrorissbehaftete Körner zur besseren Thermoschockbeständigkeit aufweisen. Die Wärmedämmschicht ist also vorzugsweise poröser als die MCrAlX-Schicht.

Die Schaufel 120, 130 kann hohl oder massiv ausgeführt sein. Wenn die Schaufel 120, 130 gekühlt werden soll, ist sie hohl und weist ggf. noch Filmkühllöcher 418 (gestrichelt angedeutet) auf.

## Patentansprüche

1. Verfahren zur Einstellung des Durchflusses eines Mediums innerhalb eines hohlen Bauteils (1, 120, 130),
das im Innern zumindest einen Kanal (10) mit verschiedenen Bereichen (4, 7) aufweist,
die (4, 7) verschiedene Strömungsquerschnitte aufweisen, wobei in dem Bereich (7) mit dem kleineren Strömungsquerschnitt durch einen ersten Diffusionsbeschichtungsprozess eine größere Wanddickenverstärkung eingestellt wird und
in dem Bereich (7) mit dem größeren Strömungsquerschnitt eine geringere Wandverdickung durch einen zweiten, von dem ersten
verschiedenen Diffusionsbeschichtungsprozess eingestellt wird,
bei dem für die Diffusionsbeschichtungsprozesse verschiedene Beschichtungsmaterialien verwendet werden und
bei dem das eine Beschichtungsmaterial (13) über das andere Beschichtungsmaterial (16) aufgebracht wird.

2. Verfahren nach Anspruch 1,
bei dem für die Diffusionsbeschichtungen Aluminisierungsprozesse verwendet werden.

3. Verfahren nach Anspruch 1 oder 2,
bei dem zwei verschiedene Beschichtungsmaterialien für die Diffusionsbeschichtungsprozesse verwendet werden.

4. Verfahren nach Anspruch 3,
bei dem für den ersten Diffusionsbeschichtungsprozess Ni₂Al₃ (16) als Aluminiumquelle verwendet wird.

5. Verfahren nach Anspruch 3 oder 4,
bei dem NiAl (13) als Aluminiumquelle für den zweiten Diffusionsbeschichtungsprozess verwendet wird.

6. Verfahren nach einem oder mehreren der Ansprüche,
bei dem die verschiedenen Diffusionsprozesse nacheinander durchgeführt werden.

7. Verfahren nach einem oder mehreren der Ansprüche,
bei dem die verschiedenen Diffusionsprozesse gleichzeitig durchgeführt werden.

## Claims

1. Method for adjusting the flow of a medium within a hollow component (1, 120, 130)
which in the interior has at least one duct (10) with different regions (4, 7)
which (4, 7) have different cross sections of flow, wherein a greater increase in the wall thickness is produced in the region (7) having the smaller cross section of flow by a first diffusion coating process, and a lesser increase in the wall thickness is produced in the region (7) having the larger cross section of flow by a second diffusion coating process, which is different from the first,
in which different coating materials are used for the diffusion coating processes, and
in which one coating material (13) is applied on top of the other coating material (16).

2. Method according to Claim 1,
in which aluminizing processes are used for the diffusion coatings.

3. Method according to Claim 1 or 2,
in which two different coating materials are used for the diffusion coating processes.

4. Method according to Claim 3,
in which Ni₂Al₃ (16) is used as aluminum source for the first diffusion coating process.

5. Method according to Claim 3 or 4,
in which NiAl (13) is used as aluminum source for the second diffusion coating process.

6. Method according to one or more of the preceding claims, in which the various diffusion processes are carried out in succession.

7. Method according to one or more of the preceding claims, in which the various diffusion processes are carried out simultaneously.

## Revendications

1. Procédé de réglage du flux d'un fluide dans un élément ( 1, 120, 130 ) creux,
qui a à l'intérieur au moins un canal ( 10 ) ayant des parties ( 4, 7 ) différentes,
lesquelles ( 4, 7 ) ont des sections transversales d'écoulement différentes,
dans lequel on établit dans la partie ( 7 ) ayant la section transversale d'écoulement la plus petite un renforcement d'épaisseur de paroi plus grand par un premier processus de revêtement par diffusion et on établit dans la partie ( 7 ) ayant la section transversale d'écoulement la plus grande un épaississement de paroi plus petit par un deuxième processus de revêtement par diffusion différent du premier,
dans lequel on utilise pour les processus de revêtement par diffusion des matériaux de revêtement différents et dans lequel on dépose un matériau ( 13 ) de revêtement sur l'autre matériau ( 16 ) de revêtement.

2. Procédé suivant la revendication 1,
dans lequel on utilise des processus d'aluminisation pour les revêtements par diffusion.

3. Procédé suivant la revendication 1 ou 2,
dans lequel on utilise deux matériaux de revêtement différents pour les processus de revêtement par diffusion.

4. Procédé suivant la revendication 1,
dans lequel on utilise du Ni₂Al₃ ( 16 ) comme source d'aluminium pour le premier processus de revêtement par diffusion.

5. Procédé suivant la revendication 3 ou 4,
dans lequel on utilise du Ni₂Al₃ ( 13 ) comme source d'aluminium pour le deuxième processus de revêtement par diffusion.

6. Procédé suivant l'une ou plusieurs des revendications précédentes,
dans lequel on effectue les processus de diffusion différents l'un après l'autre.

7. Procédé suivant l'une ou plusieurs des revendications précédentes,
dans lequel on effectue les processus de diffusion différents en même temps.
